# EUROPEAN PATENT APPLICATION

(11) **EP 4 560 609 A1**
(43) Date of publication of application: **28.05.2025**
(21) Application number: 23885059.8
(22) Date of filing: 02.11.2023
(51) Int. Cl.: G09F 9/30

(54) **SUPPORT MEMBER, DISPLAY MODULE, AND ELECTRONIC DEVICE**

(30) Priority: 04.11.2022 CN 202211379080
(71) Applicant: Huawei Technologies Co., Ltd., Shenzhen, Guangdong 518129 (CN)
(72) Inventor: QIAN, Chenyang, Shenzhen, Guangdong 518129 (CN); WANG, Yimeng, Shenzhen, Guangdong 518129 (CN); YAO, Xilin, Shenzhen, Guangdong 518129 (CN); ZHANG, Min, Shenzhen, Guangdong 518129 (CN)
(74) Representative: MERH-IP Matias Erny Reichl Hoffmann Patentanwälte PartG mbB
(86) International application number: PCT/CN2023/129391
(87) International publication number: WO 2024/094134

(57) **Abstract**

A support part, a display module, and an electronic device are provided. The support part (20) includes a bending region (21) and a plane region (22). The bending region (21) includes a first arc-shaped region (211), a transition region (212), and a second arc-shaped region (213) that are sequentially connected. The second arc-shaped region (213) is connected to the plane region (22). The transition region (213) directly faces a support portion (62) of a hinge (500) in the electronic device, and is capable of moving relative to the support portion (62). The first arc-shaped region (211) is provided with a plurality of first through holes (2111). The transition region (212) is provided with a plurality of second through holes (2121). The second arc-shaped region (213) is provided with a plurality of third through holes (2131). A direction in which the first arc-shaped region (211) faces the second arc-shaped region (213) is a width direction, and a direction perpendicular to the width direction is a length direction. Lengths of the plurality of first through holes (2111) gradually decrease in the width direction. Lengths of a portion of the plurality of second through holes (2121) gradually decrease in the width direction, and lengths of another portion of the plurality of second through holes (2121) are the same in the width direction. Lengths of the plurality of third through holes (2131) are the same in the width direction. The plurality of second through holes (2121) are further provided in the transition region (212) of the display module. In this way, a rebound force of the display module can be reduced, and a problem of a light-shadow crease can be alleviated.

## Description

### CROSS-REFERENCE TO RELATED APPLICATIONS

This application claims priority to Chinese Patent Application No. 202211379080.7, filed with the China National Intellectual Property Administration on November 4, 2022 and entitled "SUPPORT PART, DISPLAY MODULE, AND ELECTRONIC DEVICE", which is incorporated herein by reference in its entirety.

### TECHNICAL FIELD

This application relates to the field of electronic device technologies, and in particular, to a support part, a display module, and an electronic device.

### BACKGROUND

A support part in a display module is a key component in the entire display module. To achieve a bendable effect, a plurality of through holes are usually provided on the support part. Position distribution of the through holes is closely related to a bending radius, a rebound force, and the like, and an arrangement of the through holes is strongly related to a light-shadow crease.

A common support part usually includes three portions: a first arc-shaped region, an adhesive region, and a second arc-shaped region. Through holes are provided in the first arc-shaped region and the second arc-shaped region, and the support part is bonded to a hinge by disposing an adhesive in the adhesive region. However, because the adhesive may creep, a problem of the light-shadow crease existing after the display module is folded is prominent. In addition, a rebound force of the first arc-shaped region is large, resulting in a large rebound force of the display module.

### SUMMARY

This application provides a support part, a display module, and an electronic device, to reduce a rebound force generated after a display module is folded, and alleviate a problem of a light-shadow crease on the display module.

According to a first aspect of embodiments of this application, a support part is provided and used in a foldable electronic device. The support part includes a bending region and a plane region. The bending region includes a first arc-shaped region, a transition region, and a second arc-shaped region that are sequentially connected. A side edge that is of the second arc-shaped region and that is away from the first arc-shaped region is connected to the plane region. The transition region corresponds to a support portion of a hinge in the electronic device, and is capable of moving relative to the support portion. The first arc-shaped region is provided with a plurality of first through holes. The transition region is provided with a plurality of second through holes. The second arc-shaped region is provided with a plurality of third through holes. A direction in which the first arc-shaped region faces the second arc-shaped region is a width direction, and a direction perpendicular to the width direction is a length direction. Lengths of the plurality of first through holes gradually decrease in the width direction. Lengths of a portion of the plurality of second through holes gradually decrease in the width direction, and lengths of another portion of the plurality of second through holes are the same in the width direction. Lengths of the plurality of third through holes are the same in the width direction.

In this support part, the first arc-shaped region is provided with the plurality of first through holes. In this way, a material volume of the first arc-shaped region is reduced, and a rebound force of the first arc-shaped region is reduced, so that bending is easier. In addition, a length of the first arc-shaped region gradually decreases in the width direction, so that strength of the first arc-shaped region can be increased when the first arc-shaped region gets closer to the second arc-shaped region. When the support part is bent, the transition region between the first arc-shaped region and the second arc-shaped region is provided with the plurality of second through holes, so that a through hole design exists throughout the bending region. A tensile stress and a compressive stress generated in the bending region are approximately the same. When the tensile stress and the compressive stress can roughly offset each other, the support portion of the hinge does not need to support the bending region. When no force is applied to the bending region by the support portion, a problem of a light-shadow crease on the display module can be alleviated.

According to the first aspect, in a possible implementation, the plurality of first through holes are in several columns in the length direction, and first through holes in two adjacent columns are staggered in the width direction.

In this possible implementation, the plurality of first through holes are in the plurality of columns, and the plurality of first through holes are staggered in the width direction. In this way, the first arc-shaped region is arranged evenly as a whole. When the support part is bent, the rebound force generated in the first arc-shaped region is also even. This is more conducive to bending of the first arc-shaped region.

According to the first aspect, in a possible implementation, the plurality of second through holes are in several columns in the length direction. The portion of second through holes whose lengths gradually decrease are staggered in the width direction. The another portion of second through holes whose lengths are the same are provided abreast in the width direction.

In this possible implementation, the portion of second through holes are staggered in the width direction, so that a portion that is of the transition region and that is close to the first arc-shaped region generates a smaller rebound force, and a portion that is of the transition region and that is close to the first arc-shaped region can be bent more easily. In addition, the another portion of second through holes are provided abreast in the width direction, so that a portion that is of the bending region and that is away from the first arc-shaped region has higher strength than a portion that is of the bending region and that is close to the first arc-shaped region.

According to the first aspect, in a possible implementation, the plurality of third through holes are in several rows in the width direction, and third through holes in two adjacent rows are staggered.

In this possible implementation, in the width direction, third through holes in two adjacent rows are staggered. The third through holes are provided more regularly than the first through holes. For example, third through holes in each row are provided equidistantly, and a region between two second through holes in a row exactly corresponds to a third through hole in a next row. In this way, strength of the second arc-shaped region is higher than strength of the first arc-shaped region. The first arc-shaped region can be bent more easily, and a support force of the second arc-shaped region for supporting a display panel in the display module can be increased.

According to the first aspect, in a possible implementation, in the width direction, hole widths of the first through hole, the second through hole, and the third through hole are all W, and 0.01 mm≤W≤50 mm.

In this possible implementation, the hole width W of the first through hole, the second through hole, or the third through hole is set to the range of 0.01 mm to 50 mm. In combination with arrangement manners of the first through holes, the second through holes, and the third through holes, this can reduce mass of the first arc-shaped region in the support part, so that the first arc-shaped region can generate a smaller rebound force. Compared with those of the first arc-shaped region, more materials of the second arc-shaped region can be reserved, to maintain the strength of the second arc-shaped region, so that the second arc-shaped region can support the display panel in the display module. The transition region is disposed between the first arc-shaped region and the second arc-shaped region, so that the transition region implements gradual transition from a structure generating a smaller rebound force to a structure with specific strength. In this way, the first arc-shaped region and the second arc-shaped region are better obliquely connected, to avoid a possible fracture occurring when the first arc-shaped region directly reaches the second arc-shaped region.

According to the first aspect, in a possible implementation, in the width direction, hole spacings between any two adjacent first through holes, between any two adjacent second through holes, between any two adjacent third through holes, between any adjacent first through hole and second through hole, and between any adjacent second through hole and third through hole are all D1, and 0.01 mm≤D1≤50 mm.

In this possible implementation, the hole spacing D1 between any two adjacent first through holes, between any two adjacent second through holes, between any two adjacent third through holes, between any adjacent first through hole and second through hole, or between any adjacent second through hole and third through hole is set to the range of 0.01 mm to 50 mm. In one aspect, the hole spacing D1 between two adjacent first through holes, between two adjacent second through holes, or between adjacent first through hole and second through hole is set to be smaller. This can reduce a rebound force generated in the first arc-shaped region and a portion of the transition region. In another aspect, the hole spacing D1 between two adjacent second through holes, between two adjacent third through holes, or between adjacent second through hole and third through hole is set to be larger. This can increase the strength of the second arc-shaped region and a portion of the bending region.

According to the first aspect, in a possible implementation, in the length direction, hole spacings between two adjacent first through holes, between two adjacent second through holes, and between two adjacent third through holes are all D2, and 0.01 mm≤D2≤10 mm.

In this possible implementation, in the length direction, the hole spacing D2 between two first through holes, between two second through holes, or between two third through holes is set to the range of 0.01 mm to 10 mm, and the hole spacing D2 may be set as required, so that generation of the rebound force in the first arc-shaped region and the portion of the transition region of the support part can be reduced. In this way, structural strength of the second arc-shaped region and the portion of the transition region can be increased, to support the display panel in the display module.

According to the first aspect, in a possible implementation, in the length direction, hole lengths of the first through hole, the second through hole, and the third through hole are all L, and 0.01 mm≤L≤10 mm.

In this possible implementation, in the length direction, the hole length L of the first through hole, the second through hole, or the third through hole is set to the range of 0.01 mm to 10 mm, and the hole spacing L may be set as required, so that generation of the rebound force in the first arc-shaped region and the portion of the transition region of the support part can be reduced. In this way, structural strength of the second arc-shaped region and the portion of the transition region can be increased, to support the display panel in the display module.

According to the first aspect, in a possible implementation, when observed in a direction perpendicular to the support part, the first through hole, the second through hole, and the third through hole are circular, elliptical, runway-shaped, or rectangular.

In this possible implementation, the first through hole, the second through hole, and the third through hole are set to be circular, elliptical, runway-shaped, or rectangular. Shapes of the first through hole, the second through hole, and the third through hole may be changed with reference to a force applied to the display module in a bent state or an unfolded state, to reduce a force applied to the support part.

According to a second aspect of embodiments of this application, a display module is provided, applied to a foldable electronic device, including a display panel, a protective layer, and the support part according to any implementation of the first aspect. The support part, the display panel, and the protective layer are stacked. The support part is disposed on a first surface of the display panel. The protective layer is disposed on a second surface that is of the display panel and that is away from the first surface.

In this display module, the support part whose transition region is provided with the plurality of second through holes is used, to reduce a rebound force of the display panel and alleviate a problem of a light-shadow crease on the display panel. This can protect the display panel from being scratched. In addition, the protective layer may also be used as a surface in the display module for human-computer interaction, so that a user can directly perform an operation on the protective layer.

According to a third aspect of embodiments of this application, an electronic device is provided, including two housings, a hinge, and the display module according to any implementation of the second aspect. The two housings may be rotatably connected, and two opposite sides of the hinge are respectively fastened to the two housings. The display module includes two plane regions connected to the bending region. The two plane regions are symmetrically disposed on two sides of the bending region, and each plane region is connected to one of the housings.

The electronic device controls rotation by using the hinge, so that the two housings can have different rotation angles. The two housings rotate to drive the display module to be bent. The support part in the foregoing implementation is used in the display module, to reduce a rebound force of the display module generated after the two housings are bent, so that the display module is bent. In addition, the plurality of second through holes instead of an adhesive are provided in the transition region. This can alleviate a light-shadow crease of the display module, and a bending position of the display module is smoother.

According to the second aspect, in a possible implementation, the hinge includes a fastener, a connecting part, and a rotary arm. The fastener is rotatably connected to the connecting part. The connecting part is fastened to the rotary arm. The rotary arm is fastened to the housing.

In this possible implementation, the fastener is rotatably connected to the connecting part, so that the housing connected to the rotary arm can rotate, to implement folding of the two housings.

According to the second aspect, in a possible implementation, the fastener includes an arc-shaped block. The connecting part includes a support portion and a connecting portion connected to the support portion. The connecting portion is provided with an arc-shaped groove. The arc-shaped block is slidably disposed in the arc-shaped groove, and the connecting part is fastened to the rotary arm through the support portion.

In this possible implementation, the hinge can implement a rotatable connection between the rotary arm and the housings through sliding cooperation between the arc-shaped block and the arc-shaped groove, to facilitate folding of the electronic device.

### BRIEF DESCRIPTION OF DRAWINGS

FIG. 1 is a diagram of a structure of an electronic device according to an embodiment of this application, in which two housings are in a folded state;
FIG. 2 is a diagram in which the two housings of the electronic device shown in FIG. 1 are in an unfolded state, and surfaces of the two housings are located on a same plane;
FIG. 3 is an exploded view of the electronic device shown in FIG. 2.
FIG. 4 is a diagram of a partial cross-sectional structure in which the electronic device shown in FIG. 1 is in a folded state and a display module is also in the folded state;
FIG. 5 is a diagram of a structure of a display module according to an embodiment of this application;
FIG. 6 is a schematic top view of a partial structure of a support part in the display module shown in FIG. 5;
FIG. 7 is a diagram of an enlarged part corresponding to VII in the support part shown in FIG. 6;
FIG. 8 shows a light-shadow crease presented after a support part in a display module is folded when a transition region is provided without a second through hole.
FIG. 9 shows a light-shadow crease presented after a support part in a display module provided in an embodiment of this application is folded when a transition region is provided with a second through hole.
FIG. 10 is a diagram of a local stress on a bending region of a support part obtained when a display module is in a folded state;
FIG. 11 is a diagram of a structure of a hinge according to an embodiment of this application, in which a rotary arm is in a folded state; and
FIG. 12 shows the hinge shown in FIG. 11, in which a rotary arm of the hinge is in an unfolded state.

**Description of reference signs of main components:**

| | |
|---|---|
| Electronic device | 001 |
| Display module | 100 |
| Display panel | 10 |
| Support part | 20 |
| Bending region | 21 |
| First arc-shaped region | 211 |
| First through hole | 2111 |
| Transition region | 212 |
| Second through hole | 2121 |
| Second arc-shaped region | 213 |
| Third through hole | 2131 |
| Plane region | 22 |
| Protective layer | 30 |
| Adhesive | 35 |
| Hole width | W |
| Hole spacing | D1 |
| Hole spacing | D2 |
| Hole length | L |
| Center line | O |
| Radius | R |
| Included angle | θ |
| Width direction | X |
| Length direction | Y |
| Housing | 400 |
| First housing | 400a |
| Second housing | 400b |
| Housing | 40 |
| First housing | 40a |
| Second housing | 40b |
| Middle frame | 42 |
| First middle frame | 42a |
| Second middle frame | 42b |
| Rotary shaft | 44 |
| Hinge | 500 |
| Fastener | 50 |
| Arc-shaped block | 51 |
| Connecting part | 60 |
| Connecting portion | 61 |
| Arc-shaped groove | 611 |
| Support portion | 62 |
| Rotary arm | 70 |

In the following specific implementations, the present invention is further described with reference to the accompanying drawings.

### DESCRIPTION OF EMBODIMENTS

The following describes implementations of this application by using specific embodiments. A person skilled in the art may easily learn of other advantages and effects of this application based on content disclosed in this specification. Although descriptions of this application are provided with reference to preferred embodiments, this does not mean that features of this application are limited to this implementation. On the contrary, a purpose of describing this application with reference to an implementation is to cover another option or modification that may be derived based on claims of this application. To provide an in-depth understanding of this application, the following descriptions include a plurality of specific details. This application may be alternatively implemented without using these details. In addition, to avoid confusion or blurring a focus of this application, some specific details are omitted from the descriptions. It should be noted that embodiments of this application and features in the embodiments may be mutually combined in the case of no conflict.

The following terms "first", "second", and the like are merely used for description, and shall not be understood as an indication or implication of relative importance or implicit indication of a quantity of indicated technical features. Therefore, a feature limited by "first", "second", or the like may explicitly or implicitly include one or more features. In the descriptions of this application, unless otherwise stated, "a plurality of" means two or more than two. Orientation terms such as "up", "down", "left", and "right" are defined relative to an orientation of schematic placement of components in the accompanying drawings. It should be understood that these directional terms are relative concepts and are used for relative description and clarification. These directional terms may vary accordingly depending on an orientation in which the components are placed in the accompanying drawings.

In this application, unless otherwise explicitly specified and limited, the term "connection" should be understood in a broad sense. For example, the "connection" may be a fastened connection, a detachable connection, or an integrated connection; and may be a direct connection or an indirect connection by using an intermediate medium. The term "and/or" used in this specification includes any and all combinations of one or more related listed items.

When the following embodiments are described in detail with reference to diagrams, for ease of description, a diagram indicating a partial structure of a component is partially enlarged not based on a general scale. In addition, the diagrams are merely examples, and should not limit the protection scope of this application herein.

To make the objectives, technical solutions, and advantages of this application clearer, the following further describes the implementations of this application in detail with reference to the accompanying drawings.

To facilitate understanding of a display module 100 provided in embodiments of this application, an application scenario is first described.

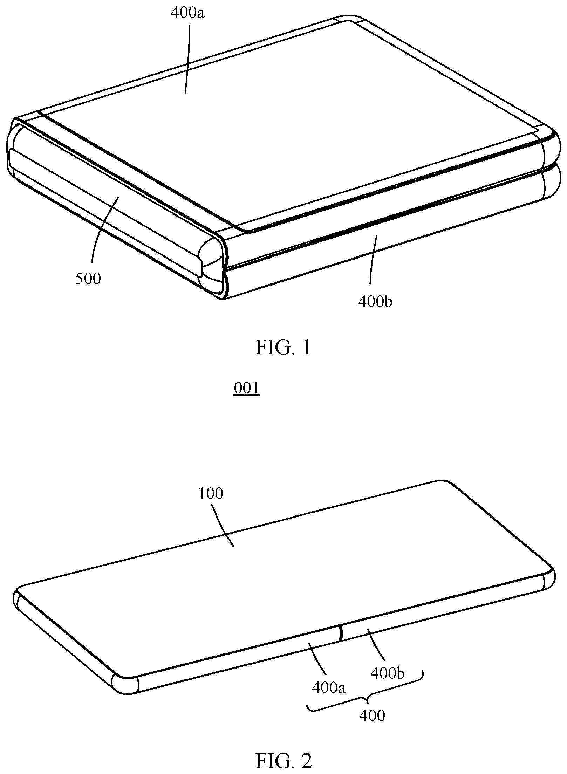

FIG. 1 is a diagram of a structure of an electronic device 001 according to an embodiment of this application, in which two housings 400 are in a folded state.

Refer to FIG. 1. The electronic device 001 provided in embodiments of this application is an electronic device that may be folded. A display module 100 provided in embodiments of this application may be used in the foldable electronic device 001. Specifically, "foldable" includes two parts that may rotate relative to each other, and a final form of the electronic device 001 may be changed through rotation, folding, or the like of the two parts. In different use conditions, a user may fold or unfold the electronic device 001 to meet different use requirements. For example, when the user needs to carry the electronic device 001, the user may fold the electronic device 001 to reduce space occupied by the electronic device 001, thereby improving portability. When the user needs to use the electronic device 001, the user may unfold the electronic device 001, so that a larger display area and a larger operation region can be presented for the user to view and interact with, thereby improving use convenience.

The electronic device 001 may be classified into a plurality of types. For example, the electronic device 001 may be a mobile phone, a tablet computer, a notebook computer, a wearable device, or an ebook. For example, the electronic device 001 in embodiments of this application is described by using a mobile phone as an example.

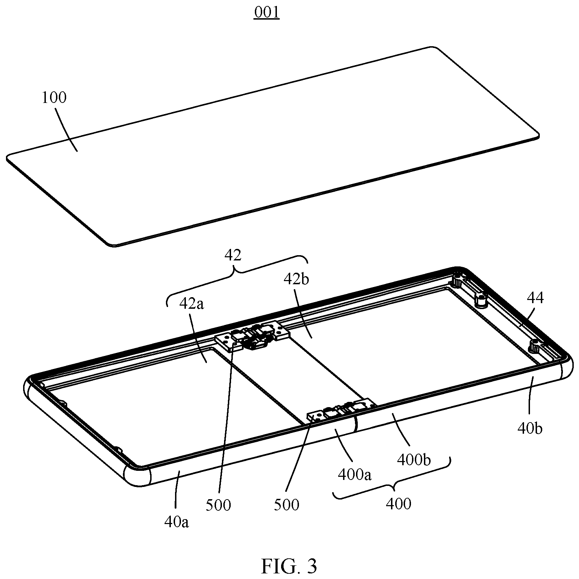

FIG. 2 is a diagram in which the two housings 400 of the electronic device 001 shown in FIG. 1 are in an unfolded state, and surfaces of the two housings 400 are located on a same plane. FIG. 3 is an exploded view of the electronic device 001 shown in FIG. 2.

Refer to FIG. 2 and FIG. 3. The electronic device 001 includes the display module 100, the two housings 400, and a hinge 500. The two housings 400 may be rotatably connected, and two opposite sides of the hinge 500 are respectively fastened to the two housings 400. Under an action of the hinge 500, motions such as rotation and movement relative to each other may occur between the two housings 400. The display module 100 is connected to the housings 400, and is disposed on the surfaces of the housings 400. When the electronic device 001 is unfolded, the surfaces of the two housings 400 on which the display module is disposed are approximately flush with each other, and the display module 100 is tiled on the surfaces of the housings 400, to provide a larger display area and a larger operation region, thereby improving use performance. When the electronic device 001 is folded, one housing 400 rotates relative to the other housing 400, and the display module 100 disposed on the housings 400 is driven by the housings 400 to bend. In the folded electronic device 001, the display module 100 may be wrapped between the two housings 400 and the hinge 500 to protect the display module 100. This prevents the display module 100 from being damaged by an external force, and can improve safety performance of the electronic device 001.

If the display module 100 and the two housings 400 move synchronously, when the two housings 400 move relative to each other by 180° from the unfolded state to the folded state, parts that are of the display module 100 and that correspond to the two housings 400 also move relative to each other by 180°. However, in a moving process of the display module 100 corresponding to the housings 400, there is a bent portion. There is an arc-shaped protrusion on the bent portion, and an obvious light-shadow crease is formed on the display module 100 due to repeated folding. In addition, because the display module 100 is driven by the housings 400 to bend, there is a rebound force at a bending position inside the display module 100. As a result, there is a small gap between the two housings 400, so that the two housings 400 cannot completely overlap each other.

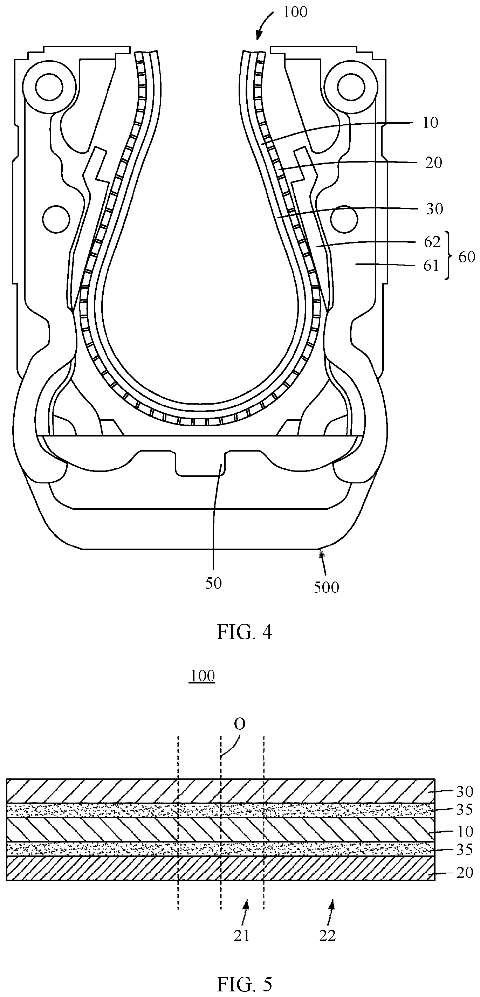

FIG. 4 is a diagram of a partial cross-sectional structure in which the electronic device 001 shown in FIG. 1 is in the folded state and the display module 100 is also in the folded state.

Refer to FIG. 4. When the housings 400 are operated to fold from the unfolded state, the housings 400 also drive the display module 100 to fold.

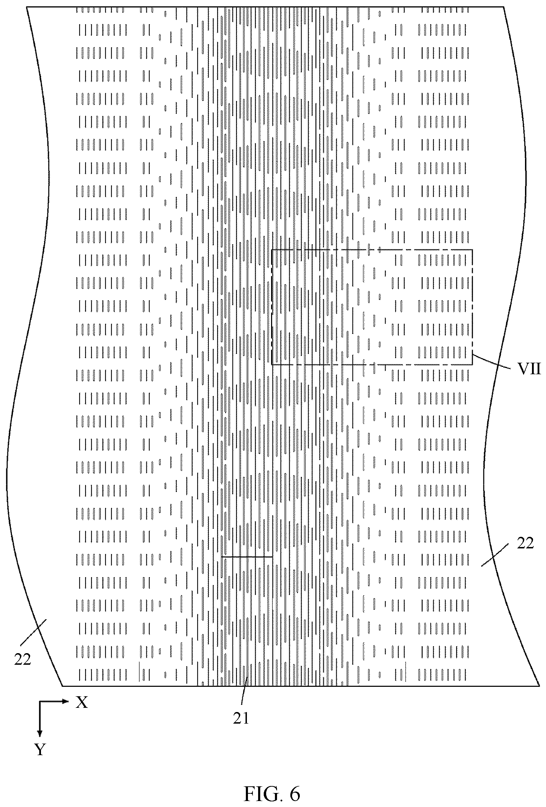

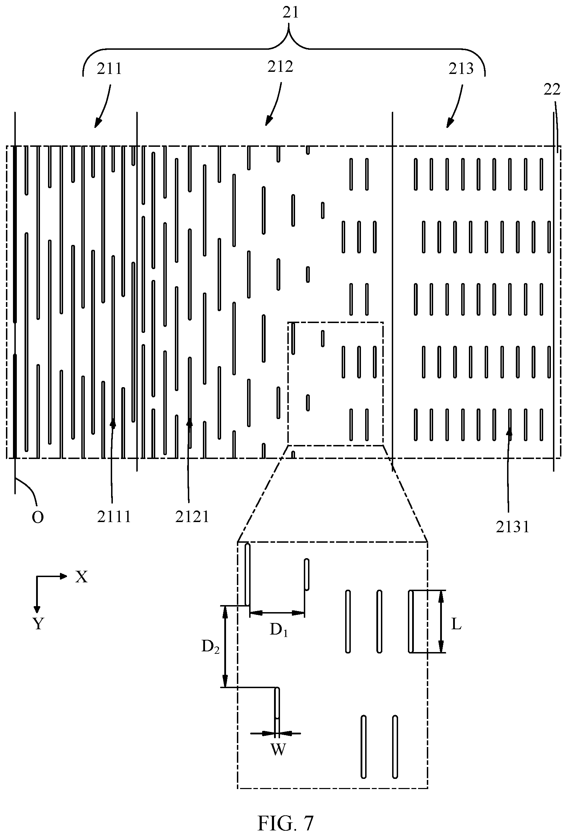

FIG. 5 is a diagram of a structure of the display module 100 according to an embodiment of this application. FIG. 6 is a schematic top view of a structure of a support part 20 in the display module 100 shown in FIG. 5. FIG. 7 is a diagram of an enlarged part of the support part 20 shown in FIG. 6.

Refer to FIG. 5, FIG. 6, and FIG. 7. Embodiments of this application provide the display module 100. The display module 100 may be used in the electronic device 001 in the foregoing embodiments.

The display module 100 includes a display panel 10, the support part 20, and a protective layer 30. The display panel 10, the support part 20, and the protective layer 30 are stacked. The support part 20 is disposed on a first surface of the display panel 10, and the protective layer 30 is disposed on a second surface that is of the display panel 10 and that is away from the first surface. With reference to an example in FIG. 5, the support part 20 is disposed on a lower surface of the display panel 10, and the protective layer 30 is disposed on an upper surface of the display panel 10. The support part 20 is mainly configured to support the display panel 10 stacked with the support part 20, so that the display panel 10 has specific strength, to facilitate an interactive operation of the user. The display module 100 may be an OLED (Organic Light-Emitting Diode) display, or may be a display of a type like an LCD (Liquid Crystal Display) or a micro-LED (Micro Light-Emitting Diode) display. Alternatively, the display module 100 may be a display like a QLED (Quantum Dot Light-Emitting Diode) display. For example, in this embodiment of this application, an OLED display is used as the display module 100 for description.

The display panel 10 may be mainly configured to display a picture, and may be used as an interaction interface that indicates to perform a series of interaction actions, for example, touch operations such as tapping, sliding, and pressing. To display the picture, the display panel 10 may include an organic electroluminescence layer and a pixel drive circuit.

The support part 20 includes a bending region 21 and a plane region 22. The bending region 21 is connected to the plane region 22. When the display panel 10 and the support part 20 are stacked, the display panel 10 is in contact with the bending region 21 and the plane region 22. The display panel 10 and the support part 20 may be bonded and fastened to each other by using an adhesive 35. For example, the display panel 10 and the support part 20 may be bonded to each other by using an OCA (Optically Clear Adhesive). The bending region 21 corresponds to a bending position of the display panel 10.

Refer to FIG. 5. The bending region 21 is a region in which the support part 20 can be bent when the display module 100 is folded. After the display module 100 is in the unfolded state, the support part 20 is unfolded accordingly, and the bending region 21 changes from a bent state to a planar state. The plane region 22 is a region other than a bent region of the support part 20 existing when the display module 100 is folded. After the display module 100 is in the unfolded state, and the support part 20 is unfolded accordingly, the plane region 22 still remains in an original state.

The support part 20 is a symmetrical structure. The support part 20 is symmetrically disposed by using a center line O of the bending region 21 as a symmetry axis. It may be understood that this means that the support part 20 includes two plane regions 22, and the two plane regions 22 are respectively connected to two opposite sides of the bending region 21. An overall contour formed by the bending region 21 and the two plane regions 22 is approximately the same as that of the display panel 10, so that each position of the display panel 10 can be fully supported. This increases strength of the display panel 10.

Refer to FIG. 4, FIG. 6, and FIG. 7. In the bending region 21 included in the support part 20, the bending region 21 includes a first arc-shaped region 211, a transition region 212, and a second arc-shaped region 213 that are sequentially connected. A side edge that is of the second arc-shaped region 213 and that is away from the first arc-shaped region 211 is connected to the plane region 22. The transition region 212 corresponds to a support portion 62 of the hinge 500 in the electronic device 001, and the transition region 212 is capable of moving relative to the support portion 62. To clearly show the first arc-shaped region 211, the transition region 212, and the second arc-shaped region 213, the first arc-shaped region 211, the transition region 212, and the second arc-shaped region 213 are separated by dashed lines. It may be understood that the bending region 21 is symmetrically disposed by using the center line O of the first arc-shaped region 211 as the symmetry axis. In other words, the two opposite sides of the bending region 21 are separately connected to the transition region 212. A side edge that is of each transition region 212 and that is away from the first arc-shaped region 211 is connected to one second arc-shaped region 213, and a side edge that is of each second arc-shaped region 213 and that is away from the first arc-shaped region 211 is connected to one plane region 22.

Refer to FIG. 6 and FIG. 7. To better describe the structure of the display module 100, a direction in which the first arc-shaped region 211 faces the second arc-shaped region 213 is considered as a width direction X, and a direction that is perpendicular to the width direction X and parallel to the center line O of the bending region 21 is considered as a length direction Y. The first arc-shaped region 211 is provided with a plurality of first through holes 2111. The transition region 212 is provided with a plurality of second through holes 2121. The second arc-shaped region 213 is provided with a plurality of third through holes 2131. Lengths of the plurality of first through holes 2111 gradually decrease in the width direction X. Lengths of a portion of the plurality of second through holes 2121 gradually decrease in the width direction X, and lengths of another portion of the plurality of second through holes 2121 are the same in the width direction X. Lengths of the plurality of third through holes 2131 are the same in the width direction.

In an embodiment, the plurality of first through holes 2111 are in several columns in the length direction Y, and first through holes 2111 in two adjacent columns are staggered in the width direction X. A partial region from the center line O of the first arc-shaped region 211 to a side edge that is of the transition region 212 and that is close to the first arc-shaped region 211 is used for description. In the length direction Y, the plurality of first through holes 2111 are in a plurality of columns, and several first through holes 2111 in each column are provided approximately equidistantly. The several first through holes 2111 in the column and several first through holes 2111 in an adjacent column are staggered.

For example, in a staggered arrangement, a column that is close to the center line O of the first arc-shaped region 211 is a first column. There is a spacing between several first through holes 2111 in the first column. In the width direction X, in a second column adjacent to the first column, a first through hole 2111 is provided at a position that is in the second column and that corresponds to the spacing. In other words, a region between two adjacent first through holes 2111 in the first column corresponds to the first through hole 2111 in the second column. In addition, because the two transition regions 212 are symmetrically disposed along the center line O of the first arc-shaped region 211, in a region from the center line O of the first arc-shaped region 211 to another side edge that is of the other transition region 212 and that is close to the first arc-shaped region 211, an arrangement manner of a plurality of first through holes 2111 is the same as that described in the foregoing content.

The plurality of first through holes 2111 are in several columns, and a first through hole 2111 in each column and a first through hole 2111 in an adjacent column are staggered. In this way, the plurality of first through holes 2111 in the first arc-shaped region 211 are evenly arranged as a whole. In addition, after the plurality of first through holes 2111 are provided, a material volume of the first arc-shaped region 211 is reduced, and a tensile stress and a compressive stress generated around the first through holes 2111 are reduced. Therefore, a rebound force is reduced, so that the first arc-shaped region 211 is bent more easily.

Lengths of the plurality of first through holes 2111 that are staggered gradually decrease in the width direction. In this way, when the display module 100 is folded, a central position of the first arc-shaped region 211 is bent more easily. For example, the lengths of the several first through holes 2111 in the first column are longer than the lengths of the first through holes 2111 in the second column, and a rebound force generated in the first column is smaller than that generated in the second column. In this way, bending can be easier. However, when the support part 20 is easy to bend, the support part 20 also supports the display panel 10. Therefore, specific strength is required to support the display panel 10. In the width direction X, the lengths of the first through holes 2111 gradually decrease. In this case, an area that is of the first arc-shaped region 211 and that corresponds to the display panel 10 gradually increases, so that strength for supporting the display panel 10 can be gradually increased. The lengths of the plurality of first through holes 2111 gradually decrease in the width direction X, so that a rebound force difference between first through holes 2111 in columns is small, and a force applied to the display panel 10 corresponding to the first arc-shaped region 211 is even. This can improve a case in which a position that is of the display panel 10 and that corresponds to the first arc-shaped region 211 is detached from the first arc-shaped region 211, thereby avoiding a problem of a light-shadow crease caused by the display panel 10 being not supported by the support part 20 at a bending position.

Refer to FIG. 7. In an embodiment, the plurality of second through holes 2121 are in several columns in the length direction Y. A portion of second through holes 2121 whose lengths gradually decrease are staggered in the width direction X, and another portion of second through holes 2121 whose lengths are the same are provided abreast in the width direction X. The transition region 212 may be roughly divided into a first region and a second region. The first region is a portion close to the bending region 21, and the second region is a portion close to the second arc-shaped region 213. In the first region, in the length direction, a portion of second through holes 2121 are in a plurality of columns, and several second through holes 2121 in each column are provided approximately equidistantly. The several second through holes 2121 in the column and several second through holes 2121 in an adjacent column are staggered.

For example, in the first region, in a staggered arrangement, a column of second through holes 2121 that is close to the first arc-shaped region 211 is a first column, and there is a spacing between several second through holes 2121 in the first column. In a second column adjacent to the first column, a second through hole 2121 is provided at a position that is in the second column and that corresponds to the spacing. In other words, a region between two adjacent second through holes 2121 in the first column corresponds to the second through hole 2121 in the second column. The portion of second through holes 2121 are staggered, so that the portion of second through holes 2121 in the first region are evenly arranged as a whole. In addition, after the portion of second through holes 2121 are provided in the first region, a material volume of the transition region 212 is reduced, and a tensile stress and a compressive stress generated around the second through holes 2121 are reduced. Therefore, a rebound force is reduced, so that the transition region 212 is bent, and there is a good process of connection between the transition region 212 and the first arc-shaped region 211. In addition, the lengths of the portion of second through holes 2121 in the first region gradually decrease in the width direction X, so that an area that is of the transition region 212 and that corresponds to the display panel 10 can be increased. In this way, the strength for supporting the display panel 10 can be gradually increased.

For another example, in the second region in the width direction X, another portion of second through holes 2121 are in a plurality of columns, and several second through holes 2121 in each column are provided approximately equidistantly; and another portion of second through holes 2121 are in a plurality of rows, and two adjacent second through holes 2121 in each row are provided approximately equidistantly. In addition, in the length direction Y, second through holes 2121 in two adjacent rows are staggered.

In a staggered arrangement in the second region, a second through hole 2121 in a first row is provided between two adjacent second through holes 2121 in a second row. In other words, a portion of second through holes 2121 in the second region are arranged according to an abreast and staggered rule. Because the two transition regions 212 are symmetrically disposed along the center line O of the first arc-shaped region 211, an arrangement manner of a first region and a second region in the other transition region 212 is the same as that described in the foregoing content. The another portion of second through holes 2121 are arranged regularly, so that the transition region 212 can be better transitionally connected to the second arc-shaped region 213 through the second region.

In the second region, the portion of second through holes 2121 that are staggered are regularly arranged abreast in the width direction X. Compared with that in the first region in which the second through holes 2121 are staggered in the width direction X, no through hole is provided between second through holes 2121 in two rows in the second region, so that structural strength of the second region is increased. In this way, the strength for supporting the display panel 10 can be increased.

Both detachment of the display panel 10 in the display module 100 from the support part 20 in the display module 100 and a force applied by the support portion 62 in the housing 400 to the display panel 10 may cause a light-shadow crease on the display module 100.

After the display module 100 is bent, the second through holes 2121 in the transition region 212 are deformed under an action of the tensile stress and the compressive stress. For example, when the display module 100 is unfolded, a projection area of the second through holes 2121 on the housing 400 is A. When the display module 100 is bent, a projection area of the second through holes 2121 on the housing 400 is B. During bending, a connection portion between the second through holes 2121 is subject to a pulling force. Therefore, the second through holes 2121 in the transition region 212 are capable of moving relative to the support portion 62, and consequently the area B is slightly larger than the area A. After the display module 100 is bent, the tensile stress and the compressive stress generated in the transition region 212 are balanced, and the support portion 62 does not need to support the display module 100. This can reduce the force applied by the support portion 62 to the display panel 10 through the transition region 212, thereby alleviating the problem of the light-shadow crease on the display module 100. In addition, because the force applied to the transition region 212 is balanced, the force applied to the display panel 10 corresponding to the transition region 212 is more even. This can avoid a case in which the display panel 10 is detached from the support part 20, thereby alleviating the problem of the light-shadow crease on the display module 100.

Refer to FIG. 7. In an embodiment, the plurality of third through holes 2131 are in several rows in the width direction X, and third through holes 2131 in two adjacent rows are provided abreast. In the length direction Y, the plurality of third through holes 2131 are in a plurality of columns, and several third through holes 2131 in each column are provided approximately equidistantly. In the width direction X, the plurality of third through holes 2131 are in a plurality of rows, and two adjacent third through holes 2131 in each row are provided approximately equidistantly. In addition, in the length direction Y, third through holes 2131 in two adjacent rows are staggered.

An arrangement manner of the another portion of second through holes 2121 in the second region in the transition region 212 is approximately the same as an arrangement manner of the plurality of third through holes 2131 in the second arc-shaped region 213. It may be understood that an arrangement manner of the other second arc-shaped regions 213 is the same as that described in the foregoing content. The plurality of third through holes 2131 in the second arc-shaped region 213 are provided abreast in the width direction X and staggered in the length direction Y, so that the second arc-shaped region 213 can function for bending transition. In this way, the bending region 21 can be freely bent, and it is ensured that the bending region 21 has specific strength at a position of the second arc-shaped region 213. The transition region 212 is connected to the second arc-shaped region 213 through the second region. This can ensure that a connection position between the transition region 212 and the second arc-shaped region 213 can be freely bent and has specific strength.

The first through holes 2111, the second through holes 2121, and the third through holes 2131 in the bending region 21 are staggered. This can avoid a problem of a possible fracture occurring when the plurality of first through holes 2111, the plurality of second through holes 2121, and the plurality of third through holes 2131 are arranged in rows or columns.

Refer to FIG. 7 again. In an embodiment, when observed in a direction in which the support part 20 stacks with the display panel 10, that is, in a direction perpendicular to the support part 20, the first through hole 2111, the second through hole 2121, and the third through hole 2131 are circular, elliptical, runway-shaped, or rectangular. For example, the first through hole 2111, the second through hole 2121, and the third through hole 2131 in this application may be in a runway shape. The runway shape is a shape formed by two ends which are approximately semicircles and a rectangle between the two semicircles in the length direction Y. It may be understood that, in another embodiment, the first through hole 2111 may be in the runway shape, and the second through hole 2121 may be elliptical. In other words, the first through hole 2111, the second through hole 2121, and the third through hole 2131 may be in different shapes.

Refer to FIG. 7. In an embodiment, in the width direction X, hole widths of the first through hole 2111, the second through hole 2121, and the third through hole 2131 are all W, and a range of W is 0.01 mm≤W≤50 mm. The hole width W is a width of the hole in the width direction X. The hole width W may be 1 mm, 5 mm, 10 mm, 15 mm, 20 mm, 25 mm, 30 mm, 35 mm, 40 mm, 45 mm, 50 mm, or the like.

The hole width W is set to the range of 0.01 mm to 50 mm. In combination with the arrangement manners of the first through holes 2111, the second through holes 2121, and the third through holes 2131, this can reduce mass of the first arc-shaped region 211 in the support part 20, so that the first arc-shaped region 211 can generate a smaller rebound force. Compared with those of the first arc-shaped region 211, more materials of the second arc-shaped region 213 can be reserved, to maintain strength of the second arc-shaped region 213, so that the second arc-shaped region 213 can support the display panel 10 in the display module 100. The transition region 212 is disposed between the first arc-shaped region 211 and the second arc-shaped region 213, so that the transition region 212 implements gradual transition from a structure generating a smaller rebound force to a structure with specific strength. In this way, the first arc-shaped region 211 and the second arc-shaped region 213 are better obliquely connected, to avoid a possible fracture occurring when the first arc-shaped region 211 directly reaches the second arc-shaped region 213.

For example, the hole width W of the first through hole 2111 is set to 15 mm; the hole width W of the second through hole is set to 10 mm or 6 mm in the width direction; and the hole width W of the third through hole 2131 is set to 5 mm. The hole width W of the first through hole 2111 is larger, so that the first arc-shaped region 211 is easier to bend. The hole width W of the third through hole 2131 is smaller, so that structural strength of the second arc-shaped region 213 is higher than that of the first arc-shaped region 211, to increase a support force of the support part 20 for the display panel 10. The hole width W of the transition region 212 gradually decreases in the width direction, so that a position that is in the transition region 212 and that is close to the first arc-shaped region 211 is easier to bend, and structural strength of a position that is in the transition region 212 and that is close to the second arc-shaped region 213 is increased.

Refer to FIG. 7. In an embodiment, in the width direction X, hole spacings between any two adjacent first through holes 2111, between any two adjacent second through holes 2121, between any two adjacent third through holes 2131, between any adjacent first through hole 2111 and second through hole 2121, and between any adjacent second through hole 2121 and third through hole 2131 are all D1, and 0.01 mm≤D1≤50 mm. The hole spacing D1 is a distance between two adjacent through holes in the width direction X. The two adjacent through holes may be two adjacent first through holes 2111, two adjacent second through holes 2121, two adjacent third through holes 2131, adjacent first through hole 2111 and second through hole 2121, or adjacent second through hole 2121 and third through hole 2131.

The hole spacing D1 may be 1 mm, 5 mm, 10 mm, 15 mm, 20 mm, 25 mm, 30 mm, 35 mm, 40 mm, 45 mm, 50 mm, or the like.

The hole spacing D1 is set to the range of 0.01 mm to 50 mm. In one aspect, the hole spacing D1 between two adjacent first through holes 2111, between two adjacent second through holes 2121, or between adjacent first through hole 2111 and second through hole 2121 is set to be smaller. This can reduce a rebound force generated in the first arc-shaped region 211 and a portion of the transition region 212. In another aspect, the hole spacing D1 between two adjacent second through holes 2121, between two adjacent third through holes 2131, or between adjacent second through hole 2121 and third through hole 2131 is set to be larger. This can increase strength of the second arc-shaped region 213 and a portion of the transition region 212.

For example, the hole spacing D1 between two first through holes 2111 is set to 3 mm; the hole spacing D1 between two second through holes 2121 is set to 5 mm; and the hole spacing D1 between two third through holes 2131 is set to 8 mm. The hole spacing D1 between two first through holes 2111 is set to be less than the hole spacing D1 between two second through holes 2121 and less than the hole spacing D1 between two third through holes 2131. This can reduce the rebound force generated in the first arc-shaped region 211, so that the support part 20 can be bent. The hole spacing D1 of the second arc-shaped region 213 is set to be larger. This can increase an area that is of the second arc-shaped region 213 and that corresponds to the display panel 10 and increase the strength of the second arc-shaped region 213, thereby increasing the support force for the display panel 10.

Refer to FIG. 7. In an embodiment, in the length direction Y, hole spacings between two adjacent first through holes 2111, between two adjacent second through holes 2121, and between two adjacent third through holes 2131 are all D2, and 0.01 mm≤D2≤10 mm. The hole spacing D2 is a distance in the length direction Y, for example, a distance between two adjacent first through holes 2111, namely, a spacing between two adjacent first through holes 2111 in several first through holes 2111 in each column.

The hole spacing D2 may be 0.05 mm, 0.1 mm, 0.15 mm, 0.2 mm, 0.25 mm, 0.3 mm, 0.35 mm, 0.4 mm, 0.45 mm, 0.5 mm, 0.55 mm, 0.6 mm, 0.65 mm, 0.7 mm, 0.75 mm, 0.8 mm, 0.85 mm, 0.9 mm, 0.95 mm, or the like.

The hole spacing D2 is set to the range of 0.01 mm to 10 mm, and the hole spacing D2 may be set as required, so that the support part 20 can reduce generation of the rebound force in the first arc-shaped region 211 and the portion of the transition region 212. In this way, structural strength of the second arc-shaped region 213 and the portion of the transition region 212 can be increased, to support the display panel 10 in the display module 100.

For example, the hole spacing D2 between two adjacent first through holes 2111 is set to 3 mm; the hole spacing D2 between two adjacent second through holes 2121 is set to 6 mm; and the hole spacing D2 between two adjacent third through holes 2131 is set to 8 mm. In the width direction X, the hole spacing D2 gradually increases, so that the bending region 21 can be easily bent and has specific strength. In this way, the bending region 21 can meet a requirement of a preset force. The preset force means that the bending region 21 can be easily bent while supporting the display panel 10.

Refer to FIG. 7. In an embodiment, in the length direction Y, hole lengths of the first through hole 2111, the second through hole 2121, and the third through hole 2131 are all L, and 0.01 mm≤L≤10 mm. The first through hole 2111 is used as an example. The hole length L is a distance between two opposite ends of the first through hole 2111 in the length direction Y. It may be understood that the same applies to the second through hole 2121 and the third through hole 2131.

The hole length L may be 0.05 mm, 0.1 mm, 0.15 mm, 0.2 mm, 0.25 mm, 0.3 mm, 0.35 mm, 0.4 mm, 0.45 mm, 0.5 mm, 0.55 mm, 0.6 mm, 0.65 mm, 0.7 mm, 0.75 mm, 0.8 mm, 0.85 mm, 0.9 mm, 0.95 mm, or the like.

The hole length L is set to the range of 0.01 mm to 10 mm, and the hole spacing L may be set as required, so that the support part 20 can reduce generation of the rebound force in the first arc-shaped region 211 and the portion of the transition region 212. In this way, structural strength of the second arc-shaped region 213 and the portion of the transition region 212 can be increased, to support the display panel 10 in the display module 100.

For example, the hole length L of the first through hole 2111 is 8 mm, and the hole lengths L of the first through holes 2111 gradually decrease when the first through holes 2111 get closer to the transition region 212. The hole lengths L of a portion of second through holes 2121 in the second through holes 2121 are 6 mm. When the portion of second through holes 2121 get closer to the second arc-shaped region 213, the hole lengths L of the second through holes 2121 gradually decrease. The hole lengths L of another portion of second through holes 2121 are 4 mm. When the portion of second through holes 2121 get closer to the second arc-shaped region 213, the hole lengths L of the second through holes 2121 remain unchanged. The hole length L of the third through hole 2131 is set to 3 mm. The hole length L of the first through hole is set to be greater than the hole lengths L of the second through hole 2121 and the third through hole 2131. This can reduce the rebound force of the first arc-shaped region 211, thereby facilitating bending of the support part 20. The hole length L of the third through hole 2131 is smaller, so that an area in which the second arc-shaped region 213 can support the display panel 10 is increased. In this way, the strength for supporting the display panel 10 is increased.

It may be understood that the hole width W, the hole spacing D1, the hole spacing D2, and the hole length L may alternatively be sizes that are not listed one by one in respective ranges. For example, the hole width W may alternatively be 0.08 mm, 0.12 mm, or the like.

When the display module 100 is folded, sizes of the first through holes 2111, the second through holes 2121, and the third through holes 2131 are set to be within these value ranges based on the foregoing content. In this way, when the bending region 21 is bent, a bending radius and a bending included angle of the bending region 21 can meet a design requirement. In addition, the force applied to the display panel 10 disposed on the support part 20 is more even.

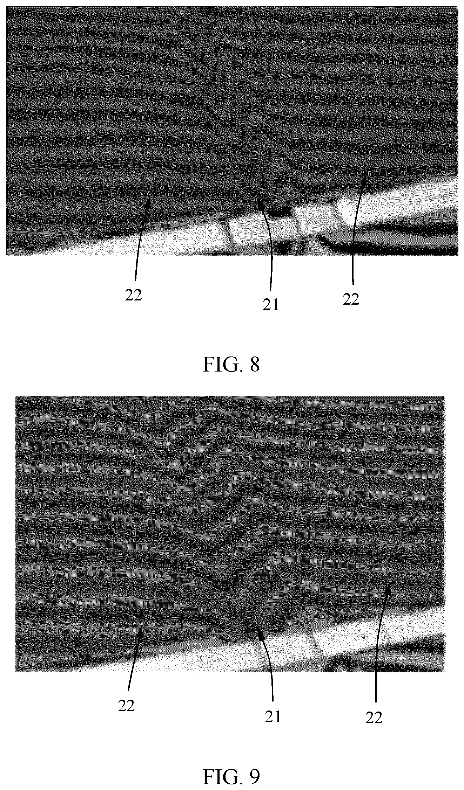

FIG. 8 shows a light-shadow crease presented after the support part 20 in the display module 100 is folded when the transition region 212 is provided without the second through hole 2121. FIG. 9 shows a light-shadow crease presented after the support part 20 in the display module 100 provided in an embodiment of this application is folded when the transition region 212 is provided with the second through hole 2121.

A common support part 20 is mainly applicable to an application scenario in which a bending radius R is large and a bending arc-shaped length is long, for example, a notebook computer. However, in an application scenario in which a bending radius is less than 2 mm and a bending arc-shaped length is less than 20 mm, if the common support part 20 is used, a rebound force of the support part 20 increases, and a light-shadow crease in the bending region 21 is serious, as shown in FIG. 8. In addition, in a process of folding, a compressive stress originally generated in the bending region 21 is high and is concentrated in the first arc-shaped region 211. Therefore, the first arc-shaped region 211 is a key part that reflects the rebound force and the light-shadow crease. When the compressive stress is higher than a tensile stress, the support part 20 generates the rebound force, and consequently the display module 100 may not be completely folded.

In this application, the transition region 212 is provided with the plurality of second through holes 2121, instead of being bonded to the hinge 500 by using the adhesive 35. In this way, the entire bending region 21 is an openwork structure formed by the plurality of first through holes 2111, the plurality of second through holes 2121, and the plurality of third through holes 2131. After the second through holes 2121 are provided in the transition region 212, the compressive stress of the first arc-shaped region 211 is reduced. When the compressive stress basically remains unchanged, the compressive stress and the tensile stress are balanced. This can reduce the rebound force generated in the first arc-shaped region 211. In addition, when the tensile stress and the compressive stress of the first arc-shaped region 211 are balanced, the support force applied by the bending region 21 to the display panel 10 is also balanced.

In addition, after the plurality of second through holes 2121 are provided in the transition region 212, no adhesive is used to bond the transition region 212 to the support portion 62 of the hinge 500. When the force applied to the first arc-shaped region 211 is balanced, no force is generated on the support portion 62 of the hinge 500. Therefore, the support portion 62 of the hinge 500 does not generate any force in the first arc-shaped region 211. The display panel 10 can be prevented from being detached from the bending region 21, and the force generated by the hinge 500 on the display panel 10 through the support part 20 can be eliminated. This alleviates the problem of the light-shadow crease on the display panel 10 shown in FIG. 9.

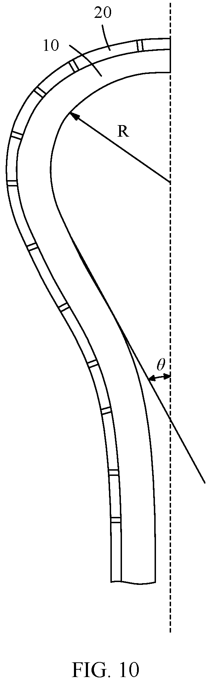

FIG. 10 is a diagram of a local stress on the bending region 21 of the support part 20 obtained when the display module 100 is in the folded state.

Refer to FIG. 4 and FIG. 10. The transition region 212 is no longer bonded to the support portion 62 of the hinge 500, and the plurality of second through holes 2121 are provided in the transition region 212. The first arc-shaped region 211 can directly extend to the second arc-shaped region 213 through the transition region 212, so that the first arc-shaped region 211 and the second arc-shaped region 213 are no longer separated. When the display module 100 is bent, the bending region 21 of the support part 20 may be roughly in a free-water droplet shape. "Roughly" may be understood as "look like". The bending region 21 roughly in the free-water droplet shape has a small bending radius R and a small tilt included angle θ, and is applicable to the display module 100 whose bending radius R is less than 2 mm, whose total arc-shaped length is less than 20 mm, and whose bending included angle θ is small.

The bending region 21 and the plane region 22 may be an integrally formed structure. It may be understood that the bending region 21 and the plane region 22 may alternatively be disposed as a detachable structure. When the bending region 21 and the plane region 22 are a detachable structure, the bending region 21 may be disposed as a structure similar to a "bracket". The bending region 21 of the "bracket" structure may be bent. The support part 20 may be made of a metal part or a fiber composite part. The first through holes 2111, the second through holes 2121, and the third through holes 2131 on the support part 20 may be formed through etching.

Refer to FIG. 5 again. The protective layer 30 is disposed on a side that is of the display panel 10 and that is away from the support part 20. The protective layer 30 is mainly configured to protect the display panel 10, and the protective layer 30 may be further used as an outer surface of the display module 100 for the user to perform a touch operation. The protective layer 30 may be made of ultra-thin glass (Ultra-Thin Glass, UTG), so that the protective layer 30 can also implement functions such as being bent and folded.

It may be understood that the protective layer 30 may alternatively be made of another material having an equivalent effect or function, for example, may alternatively be made of polyimide (Polyimide, PI).

The protective layer 30 may alternatively be bonded and fastened to the display panel 10 by using the adhesive 35, for example, bonded by using an OCA (Optically Clear Adhesive). When the support part 20 is bonded to the display panel 10 by using the OCA, the OCA does not flow into the third through hole 2131 because the OCA has a specific modulus.

Refer to FIG. 3 again. The two housings 400 are symmetrically disposed on two sides of the hinge 500, and the hinge 500 drives the two housings 400 to rotate relative to each other.

Each housing 400 includes a housing 40 and a middle frame 42 (the middle frame 42 in FIG. 3 is processed to be transparent). The housing 40 has an accommodating cavity, and the middle frame 42 is disposed in the accommodating cavity and may be exposed from the housing 40. The housing 400 further includes a rotary shaft 44. A guide groove is provided at an end that is of the housing 40 and that is away from the hinge 500. The rotary shaft 44 rotatably cooperates with the housing 40 through the guide groove, and the middle frame 42 is rotatably connected to the rotary shaft 44. The rotary shaft 44 enables the housing 40 to rotatably cooperate with the middle frame 42. As the middle frame 42 and the housing 40 rotate relative to each other, a side that is of the middle frame 42 and that is close to the hinge 500 can be accommodated in the accommodating cavity.

For ease of description, the two housings 400 are named a first housing 400a and a second housing 400b. Correspondingly, a housing of the first housing 400a is a first housing 40a, and the middle frame of the first housing 400a is a first middle frame 42a. A housing of the second housing 400b is a second housing 40b, and the middle frame of the second housing 400b is a second middle frame 42b. The display module 100 is fastened to a surface that is of the middle frame 42 and that is away from the accommodating cavity. The display module 100 is fastened to the first middle frame 42a and the second middle frame 42b through the two plane regions 22 in the support part 20. The two plane regions 22 may be bonded and fastened to the first middle frame 42a and the second middle frame 42b by using the adhesive 35.

It may be understood that the two plane regions 22 may alternatively be fastened to the first middle frame 42a and the second middle frame 42b in another manner, for example, may alternatively be fastened through clamping.

The first housing 400a and the second housing 400b rotate relative to each other, so that the display module 100 can be switched between the unfolded state and the bent state. The guide groove further has a specific extension from being close to the hinge 500 to being away from the hinge 500, and the rotary shaft 44 may slide in the guide groove, so that the middle frame 42 can further be close to or away from the hinge 500. The middle frame 42 may be close to or away from the hinge 500. This can facilitate mounting of the display module 100, so that the display module 100 can be flatly unfolded.

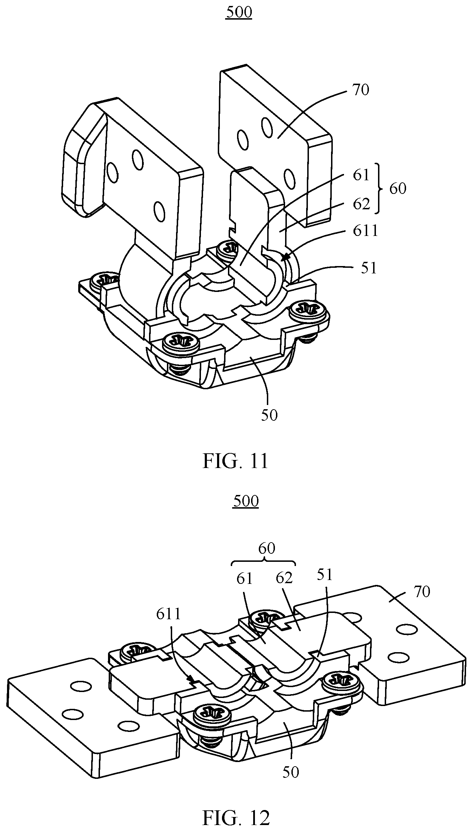

A battery, a camera module, an antenna module, and the like may be disposed between the middle frame 42 and the display module 100, so that the electronic device 001 can implement a specific function, to meet a user requirement. FIG. 11 is a diagram of a structure of a hinge 500 according to an embodiment of this application, in which a rotary arm 70 is in a folded state. FIG. 12 shows the hinge 500 shown in FIG. 11, in which the rotary arm 70 of the hinge 500 is in an unfolded state.

Refer to FIG. 11 and FIG. 12. In an embodiment, the hinge 500 includes a fastener 50, a connecting part 60, and the rotary arm 70 that are rotatably connected. The fastener 50 is rotatably connected to the connecting part 60. The connecting part 60 is fastened to the rotary arm 70. The rotary arm 70 is fastened to the housing 400. The connecting part 60 is rotatably connected to the fastener 50, so that the rotary arm 70 connected to the connecting part 60 can rotate relative to the fastener 50, and the housing 400 can rotate relative to the fastener 50. When one housing 400 is operated, the two housings 400 can rotate relative to each other by using the hinge 500, so that the electronic device 001 can be folded.

Refer to FIG. 11 and FIG. 12 again. In an embodiment, the fastener 50 includes an arc-shaped block 51. The connecting part 60 includes the support portion 62 and a connecting portion 61 connected to the support portion 62, and the connecting portion 61 is provided with an arc-shaped groove 611. The arc-shaped block 51 may be rotatably disposed in the arc-shaped groove 611, and the connecting part 60 is fastened to the rotary arm 70 through the support portion 62. The fastener 50 and the connecting part 60 are rotatably connected through sliding of the arc-shaped block 51 in the arc-shaped groove 611. When the electronic device 001 is in the unfolded state, the arc-shaped block 51 may be accommodated in the arc-shaped groove 611. Compared with a manner of connecting the fastener 50 to the connecting part 60 by using a cylindrical shaft, a manner of cooperation between the arc-shaped block 51 and the arc-shaped groove 611 can avoid a problem of interference between the display module 100 and the cylindrical shaft.

The support portion 62 may be fastened to the rotary arm 70 through welding. The rotary arm 70 may be fastened to the housing 400 by using a bolt.

When the display module 100 is connected to the housing 400, a side that is of the hinge 500 and that faces the display module 100 is also covered. When the common support part 20 corresponds to the hinge 500, the transition region 212 directly faces the support portion 62 of the hinge 500. To connect the support part 20 to the hinge 500, the OCA is disposed in the transition region 212, so that the transition region 212 can be bonded to the support portion 62 of the hinge 500. However, when the electronic device 001 is folded, to overcome the rebound force of the support part 20, the support portion 62 provides a support force for the transition region 212. The force provided by the support portion 62 is transferred to the display panel 10 through the transition region 212, resulting in a light-shadow crease on the display panel 10. In addition, the OCA may creep, which further aggravates the light-shadow crease.

In this application, the adhesive 35 is not disposed in the transition region 212, and the plurality of second through holes 2121 are provided in the transition region 212, so that the rebound force of the bending region 21 can be reduced, and the force applied to the bending region 21 is balanced. There is no need to apply a force to the support part 20 by using the support portion 62, so that the force originally transmitted by the support portion 62 to the display panel 10 through the bending region 21 disappears. This alleviates the problem of the light-shadow crease on the display panel 10.

The two housings 400 of the electronic device 001 rotate by using the hinge 500, so that the housings 400 have different rotation angles. The housings 400 are connected to the display module 100. When the two housings 400 rotate to the folded state, the display module 100 may be driven to fold. For the support part 20 used in the display module 100, the plurality of second through holes 2121 are provided in the transition region 212, so that the entire bending region 21 can be in the water droplet shape after folding. Compared with a common case in which a bonding part like the OCA is disposed in the transition region 212, this can reduce the rebound force of the support part 20 by 30%, and an effect of alleviating the light-shadow crease can be improved by 30%. In addition, the display module 100 using the support part 20 can be applied to an application scenario in which a bending radius is small, a bending arc-shaped length is small, and a tilt included angle is small.

## Claims

1. A support part, used in a foldable electronic device, comprising:
a plane region; and
a bending region, comprising a first arc-shaped region, a transition region, and a second arc-shaped region that are sequentially connected, wherein a side edge that is of the second arc-shaped region and that is away from the first arc-shaped region is connected to the plane region, and the transition region corresponds to a support portion of a hinge in the electronic device and is capable of moving relative to the support portion;
the first arc-shaped region is provided with a plurality of first through holes, the transition region is provided with a plurality of second through holes, and the second arc-shaped region is provided with a plurality of third through holes;
a direction in which the first arc-shaped region faces the second arc-shaped region is a width direction, and a direction perpendicular to the width direction is a length direction;
lengths of the plurality of first through holes gradually decrease in the width direction;
lengths of a portion of the plurality of second through holes gradually decrease in the width direction, and lengths of another portion of the plurality of second through holes are the same in the width direction; and
lengths of the plurality of third through holes are the same in the width direction.

2. The support part according to claim 1, wherein the plurality of first through holes are in several columns in the length direction, and first through holes in two adjacent columns are staggered in the width direction.

3. The support part according to claim 1, wherein the plurality of second through holes are in several columns in the length direction;
the portion of second through holes whose lengths gradually decrease are staggered in the width direction; and
the another portion of second through holes whose lengths are the same are provided abreast in the width direction.

4. The support part according to claim 1, wherein the plurality of third through holes are in several rows in the width direction, and third through holes in two adjacent rows are staggered.

5. The support part according to any one of claims 1 to 4, wherein in the width direction, hole widths of the first through hole, the second through hole, and the third through hole are all W, and 0.01 mm≤W≤50 mm.

6. The support part according to any one of claims 1 to 4, wherein in the width direction, hole spacings between any two adjacent first through holes, between any two adjacent second through holes, between any two adjacent third through holes, between any adjacent first through hole and second through hole, and between any adjacent second through hole and third through hole are all D1, and 0.01 mm≤D1≤50 mm.

7. The support part according to any one of claims 1 to 4, wherein in the length direction, hole spacings between two adjacent first through holes, between two adjacent second through holes, and between two adjacent third through holes are all D2, and 0.01 mm≤D2≤10 mm.

8. The support part according to any one of claims 1 to 4, wherein in the length direction, hole lengths of the first through hole, the second through hole, and the third through hole are all L, and 0.01 mm≤L≤10 mm.

9. The support part according to claim 1, wherein when observed in a direction perpendicular to the support part, the first through hole, the second through hole, and the third through hole are circular, elliptical, runway-shaped, or rectangular.

10. A display module, used in a foldable electronic device, comprising:
a display panel, a protective layer, and the support part according to any one of claims 1 to 9, wherein
the support part, the display panel, and the protective layer are stacked, the support part is disposed on a first surface of the display panel, and the protective layer is disposed on a second surface that is of the display panel and that is away from the first surface.

11. An electronic device, comprising two housings, a hinge, and the display module according to claim 10, wherein
the two housings are rotatably connected;
two opposite sides of the hinge are respectively fastened to the two housings; and
the display module comprises two plane regions connected to the bending region, the two plane regions are symmetrically disposed on two sides of the bending region, and each plane region is connected to one of the housings.

12. The electronic device according to claim 11, wherein the hinge comprises a fastener, a connecting part, and a rotary arm; and
the fastener is rotatably connected to the connecting part, the connecting part is fastened to the rotary arm, and the rotary arm is fastened to the housing.

13. The electronic device according to claim 12, wherein the fastener comprises an arc-shaped block, the connecting part comprises a support portion and a connecting portion connected to the support portion, and the connecting portion is provided with an arc-shaped groove; and
the arc-shaped block is slidably disposed in the arc-shaped groove, and the connecting part is fastened to the rotary arm through the support portion.
